# EUROPEAN PATENT APPLICATION

(11) **EP 1 134 660 A2**
(43) Date of publication of application: **19.09.2001**
(21) Application number: 01300105.2
(22) Date of filing: 08.01.2001
(51) Int. Cl.: G06F 11/26

(54) **Test mode entering in an integrated circuit for use in floppy disk drive apparatus**

(30) Priority: 14.03.2000 JP 2000071235
(71) Applicant: ALPS ELECTRIC CO., LTD., Ota-ku Tokyo 145 (JP)
(72) Inventor: Haitani, Munehisa, Ota-ku, Tokyo 145 (JP)
(74) Representative: Kensett, John Hinton

(57) **Abstract**

In a method and a device for entering a test mode in an integrated circuit for use in a floppy disk drive apparatus, the integrated circuit enters the test mode on condition that an enter-test-mode command is input within a predetermined period after the floppy disk drive apparatus is powered on, thereby being prevented from accidentally entering the test mode while operating in a normal mode.

## Description

### BACKGROUND OF THE INVENTION

### 1. Field of the Invention

The present invention relates to a method and a device for entering a test mode in an IC (integrated circuit) for use in an FDD (floppy disk drive) apparatus, and to an FDD apparatus. More particularly, the present invention relates to a method and a device for entering a test mode in an IC for use in an FDD apparatus, in which the IC enters the test mode upon input of an enter-test-mode command, and to an FDD apparatus incorporating the method and the device.

### 2. Description of the Related Art

Before being shipped, FDD apparatuses undergo inspection of ICs incorporated therein. For the purpose of the shipping inspection, a test mode is provided for the ICs. Entry into the test mode is implemented by, for example, entering a test command to a dedicated input terminal, or applying a signal having particular conditions (timing, voltage, etc.) to an input terminal of the FDD apparatus, which may be a hidden enter-test-mode command consisting of a specific series of "1"s and "0"s. In carrying out the inspection, it is necessary to ensure that the FDD apparatus does not accidentally enter the test mode while operating in a normal mode.

In accordance with the conventional method for entering the test mode in an IC for use in FDD apparatus, however, there has been a problem that a signal coinciding with the hidden command may be generated, for example, due to external noise, so that the IC accidentally enters the test mode, causing an erroneous operation of the FDD apparatus.

### SUMMARY OF THE INVENTION

Accordingly, it is an object of the present invention to provide a method and a device for entering a test mode in an IC for use in FDD apparatus, in which the IC is prevented from accidentally entering the test mode while operating in a normal mode, even in the event of input of a hidden enter-test-mode command or a signal coinciding with the hidden command. It is another object of the present invention to provide an FDD apparatus incorporating the method and the device.

To this end, according to one aspect of the present invention, there is provided a method for entering a test mode in an integrated circuit for use in a floppy disk drive apparatus, in which the integrated circuit for use in the floppy disk drive apparatus enters the test mode upon input of an enter-test-mode command, wherein the integrated circuit enters the test mode on condition that the enter-test-mode command is input within a predetermined period after the floppy disk drive apparatus is powered on.

The IC is allowed to enter the test mode only when an enter-test-mode command is input during a pre-operation period from when the FDD apparatus is powered on until the FDD apparatus starts normal operation. Therefore, the IC for use in the FDD apparatus is prevented from accidentally entering the test mode while operating in a normal mode even if the enter-test-mode command or a signal coinciding therewith is input.

Preferably, the integrated circuit for use in the floppy disk drive apparatus enters a normal mode upon completion of the predetermined period unless the enter-test-mode command is input within the predetermined period after the floppy disk drive apparatus is powered on.

If the test mode command is not input within the predetermined time, the IC for use in the FDD apparatus automatically enters the normal mode, ensuring stable entry into the normal mode and thereby enhancing the reliability of the FDD apparatus.

It is also preferable that the predetermined period begins after a power supply voltage and a clock have stabilized and lasts while the enter-test-mode command can be stably received.

Thus, the IC is allowed to enter the test mode stably and securely.

According to another aspect of the present invention, there is provided a device for entering a test mode in an integrated circuit for use in a floppy disk drive apparatus, the device having a test/normal mode selecting unit, provided in the integrated circuit for use in the floppy disk drive apparatus, for selecting the test mode of the integrated circuit for use in the floppy disk drive apparatus on condition that an enter-test-mode command is input within a predetermined period after the floppy disk drive apparatus is powered on.

Thus, the IC is prevented from accidentally entering the test mode while operating in a normal mode.

According to yet another aspect of the present invention, there is provided a floppy disk drive apparatus including an integrated circuit for use in floppy disk drive apparatus, which enters a test mode on condition that a enter-test-mode command is input within a predetermined period after the floppy disk drive apparatus is powered on; a spindle motor driven by a motor driver integrated circuit under control of the integrated circuit for use in the floppy disk drive apparatus when the integrated circuit for use in the floppy disk drive apparatus is operating in a normal mode; a head for reading data from and writing data to a floppy disk driven by the spindle motor; and a stepping motor for actuating the head.

The IC is prevented from accidentally entering the test mode while operating in a normal mode; accordingly, the FDD apparatus is prevented from erroneous operation.

### BRIEF DESCRIPTION OF THE DRAWINGS

Fig. 1 is a block diagram of an FDD apparatus in which, in accordance with an embodiment of the present invention, a method for entering a test mode in an IC for use in FDD apparatus is implemented;
Fig. 2 is a timing diagram showing the status of each of the blocks in Fig. 1 when the IC enters the test mode;
Fig. 3 is a timing diagram showing the status of each of the blocks in Fig. 1 when the IC enters a normal mode;
Fig. 4 is a table showing the status of each of the blocks in Fig. 1; and
Fig. 5 is a flow chart of the method for entering the test mode according to the present invention.

### DESCRIPTION OF THE PREFERRED EMBODIMENT

An embodiment of the present invention is described hereinbelow with reference to the accompanying drawings.

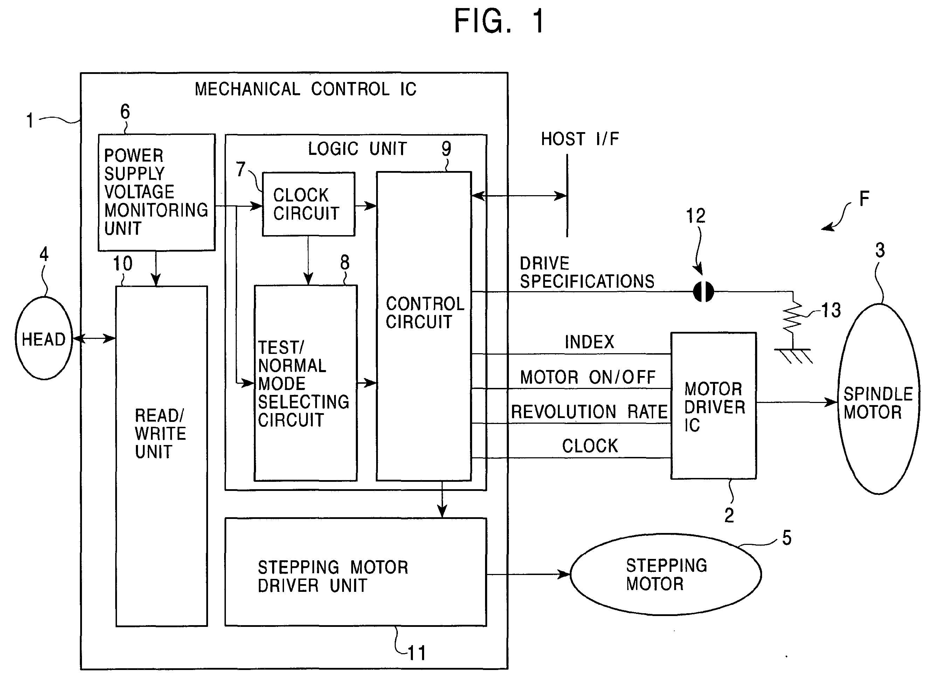

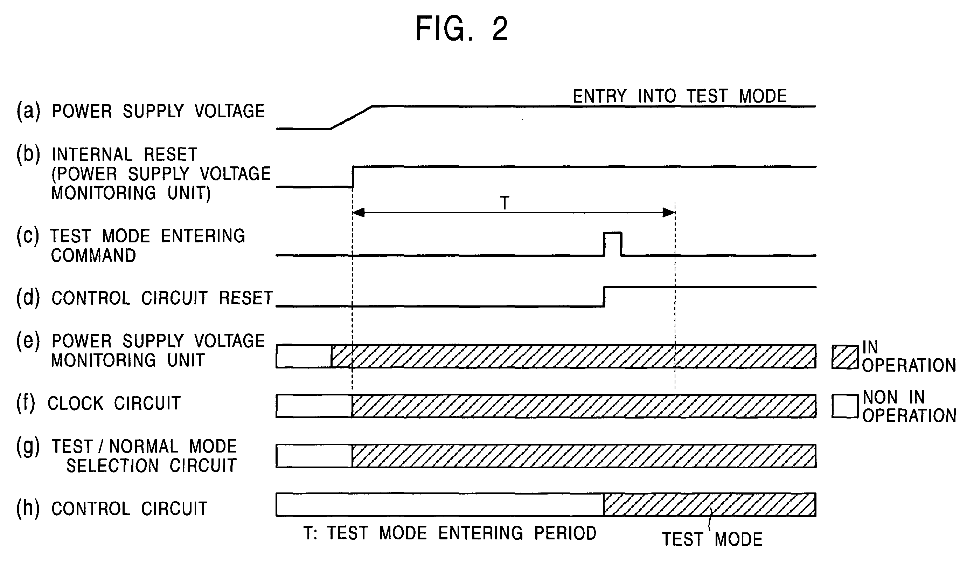

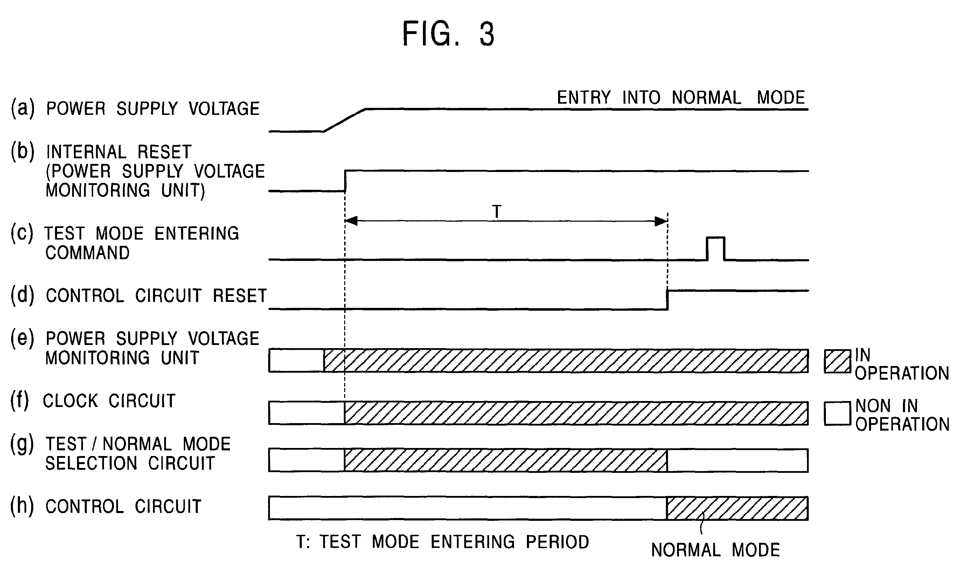

Fig. 1 is a block diagram of an FDD apparatus in which, in accordance with the present invention, a method for entering a test mode is implemented; Figs. 2 and 3 are timing diagrams showing the status of each of the blocks when an IC incorporated in the FDD apparatus enters the test mode and a normal mode, respectively.

Referring to Fig. 1, an FDD apparatus according to this embodiment includes a mechanical control IC 1, which is an IC for use in the FDD apparatus, connected to a host (not shown) via a host I/F, a motor driver IC 2 which operates under the control of the mechanical control IC 1, a spindle motor 3 driven by the motor driver IC 2, a head 4 for reading data from and writing data to an FD (Floppy Disk), and a stepping motor 5 for actuating the head 4 with high precision.

The mechanical control IC 1 includes a power supply voltage monitoring unit 6 for constantly monitoring the power supply voltage supplied to each of the components of the mechanical control IC 1, a clock circuit 7 for generating clock signals which serve as a reference for operation of each of the components, and a test/normal mode selecting circuit 8 for switching the operation of a control circuit 9, to be described below, between a test mode and a normal mode.

The control circuit 9 supplies to the motor driver IC 2 signals for turning the spindle motor 3 on and off in response to external instructions, signals for changing the revolution rate, and the clock signals. The control circuit 9 also receives from the spindle motor 3 via the motor driver IC 2 index signals for determining, for example, the starting position of data writes on the FD, and forwards the signals to the host via the host I/F.

The mechanical control IC 1 further includes a read/write unit 10 for controlling the head 4 so as to read data from and write data to the FD. The mechanical control IC 1 also includes a stepping motor driver unit 11 which, under control of the control circuit 9, controls the stepping motor 5. Between the control circuit 9 and the ground, there is provided a jumper land 12 for setting the specifications of disk drive in accordance with the type of FD, and a resistor 13 is provided between the jumper land 12 and the ground.

Next, operation of the FDD apparatus shown in Fig. 1 is described with reference to the timing diagrams in Figs. 2 and 3. Referring to Fig. 2, when a power switch is turned on, as in (a), a power supply voltage is supplied to each of the components of the mechanical control IC 1, and the power supply voltage monitoring unit 6 is internally reset, as in (b), so that power supply voltage is supplied to the respective components of the mechanical control IC 1. The power supply voltage monitoring unit 6 and the clock circuit 7 continue to operate after the power supply switch is turned on, as in (e) and (f). If a hidden enter-test-mode command is input within a predetermined period T after the power supply switch is turned on, as in (c), the test/normal mode selecting circuit 8 selects and latches the test mode, and then the control circuit 9 is released from a reset state, as in (d). At this time, the test/normal mode selecting circuit 8 is still operating, as in (g). The control circuit 9 starts operating in the test mode at this timing, as in (h), and then the IC for use in FDD apparatus undergoes inspection by an IC tester.

On the other hand, referring to Fig. 3, if a hidden enter-test-mode command is not input within the predetermined period T, the power supply voltage monitoring unit 6 and the clock circuit 7 continue to operate, as in (e) and (f); however, the test/normal mode selecting circuit 8 selects and latches the normal mode, and then enables the operation of the control circuit 9, as in (d). At this time, the test/normal mode selecting circuit 8 stops operating, as in (g). The control circuit 9 starts operating in the normal mode, as in (h), and then the IC for use in the FDD apparatus functions so as to read data from or write data to the FD. Even if the hidden enter-test-mode command is input after the predetermined period T has elapsed, the command is disregarded so that entry into the test mode is disabled, thereby preventing erroneous operation of the FDD apparatus.

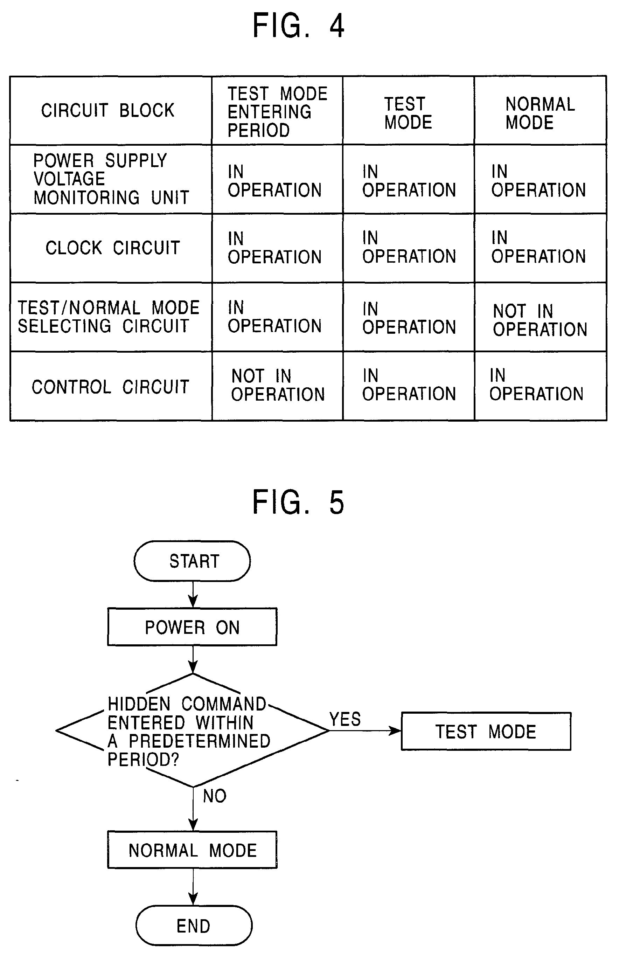

Fig. 4 shows the status of the power supply voltage monitoring unit 6, the clock circuit 7, the test/normal mode selecting circuit 8, and the control circuit 9 during the test mode entering period, during test mode operation, and during normal mode operation. Fig. 5 is a flow chart of a method of entering the test mode. Referring to Fig. 5, the FDD apparatus is powered on in Step 1, and it is checked in Step 2 whether the hidden enter-test-mode command is input within the predetermined period T. If the command is input within the predetermined period T, the IC for use in the FDD apparatus enters the test mode in Step 3; and if the predetermined period T elapses without input of the command, the IC for use in the FDD apparatus enters the normal mode in Step 4.

## Claims

1. A method for entering a test mode in an integrated circuit for use in a floppy disk drive apparatus, in which the integrated circuit for use in the floppy disk drive apparatus enters the test mode upon input of an enter-test-mode command, wherein the integrated circuit enters said test mode on condition that said enter-test-mode command is input within a predetermined period after the floppy disk drive apparatus is powered on.

2. A method for entering a test mode in an integrated circuit for use in a floppy disk drive apparatus according to Claim 1, wherein the integrated circuit for use in the floppy disk drive apparatus enters a normal mode after said predetermined period unless said enter-test-mode command is input within the predetermined period after the floppy disk drive apparatus is powered on.

3. A method for entering a test mode in an integrated circuit for use in a floppy disk drive apparatus according to Claim 1, wherein said predetermined period begins after a power supply voltage and a clock have stabilized and lasts while said enter-test-mode command can be stably received.

4. A device for entering a test mode in an integrated circuit for use in a floppy disk drive apparatus, said device comprising:
test/normal mode selecting means, provided in the integrated circuit for use in the floppy disk drive apparatus, for selecting the test mode of the integrated circuit for use in the floppy disk drive apparatus on condition that an enter-test-mode command is input within a predetermined period after the floppy disk drive apparatus is powered on.

5. A floppy disk drive apparatus comprising:
an integrated circuit for use in the floppy disk drive apparatus, which enters a test mode on condition that an enter-test-mode command is input within a predetermined period after said floppy disk drive apparatus is powered on;
a spindle motor driven by a motor driver integrated circuit under the control of said integrated circuit for use in floppy disk drive apparatus when said integrated circuit for use in the floppy disk drive apparatus is operating in a normal mode;
a head for reading data from and writing data to a floppy disk driven by said spindle motor; and
a stepping motor for actuating said head.
